(19) Europäisches Patentamt
European Patent Office
Office européen des brevets

(11) **EP 2 187 525 B1**

(12) **EUROPEAN PATENT SPECIFICATION**

(45) Date of publication and mention
of the grant of the patent:
**12.03.2014 Bulletin 2014/11**

(21) Application number: **07792110.4**

(22) Date of filing: **07.08.2007**

(51) Int Cl.:
***H03M 13/09*** (2006.01)      ***H04L 1/00*** (2006.01)

(86) International application number:
**PCT/JP2007/065441**

(87) International publication number:
**WO 2009/019763 (12.02.2009 Gazette 2009/07)**

(54) **ERROR DETECTION DEVICE, AND ERROR CORRECTION/ERROR DETECTION DECODING DEVICE AND METHOD**

FEHLERDETEKTIONSEINRICHTUNG UND FEHLERKORREKTUR-/ FEHLERDETEKTIONSDEKODIERUNGSEINRICHTUNG UND VERFAHREN

DISPOSITIF DE DÉTECTION D'ERREUR, ET DISPOSITIF ET PROCÉDÉ DE DÉCODAGE À CORRECTION D'ERREUR/DÉTECTION D'ERREUR

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**19.05.2010 Bulletin 2010/20**

(73) Proprietor: **Fujitsu Limited**
**Kawasaki-shi, Kanagawa 211-8588 (JP)**

(72) Inventor: **IKEDA, Norihiro**
**Kawasaki-shi**
**Kanagawa 211-8588 (JP)**

(74) Representative: **Fenlon, Christine Lesley**
**Haseltine Lake LLP**
**Lincoln House, 5th Floor**
**300 High Holborn**
**London WC1V 7JH (GB)**

(56) References cited:
**JP-A- 2005 006 188**

• **JULIAN SATRAN ET AL: "Out of Order Incremental CRC Computation" IEEE TRANSACTIONS ON COMPUTERS, IEEE SERVICE CENTER, LOS ALAMITOS, CA, US, 1 September 2005 (2005-09-01), pages 1178-1181, XP002491180 ISSN: 0018-9340 [retrieved on 2005-07-15]**

**Description**

TECHNICAL FIELD

The present invention relates to an error detection device, error correction/error detection decoding device and method thereof.

BACKGROUND ART

Error detection code is used in systems such as data communication systems that require that data be transmitted without errors (as in US2003/0066011A for example), and in systems such as external memory devices that require data to be read without error, and is used for detecting transmission errors and reading errors. In "Out of Order Incremental CRC Computation" (IEEE Transon Computers, Vol 54, No 9, 2005), partial CRCs are computed by calculating partial remainder values, and adding these partial remainder values together to obtain the final CRC value.

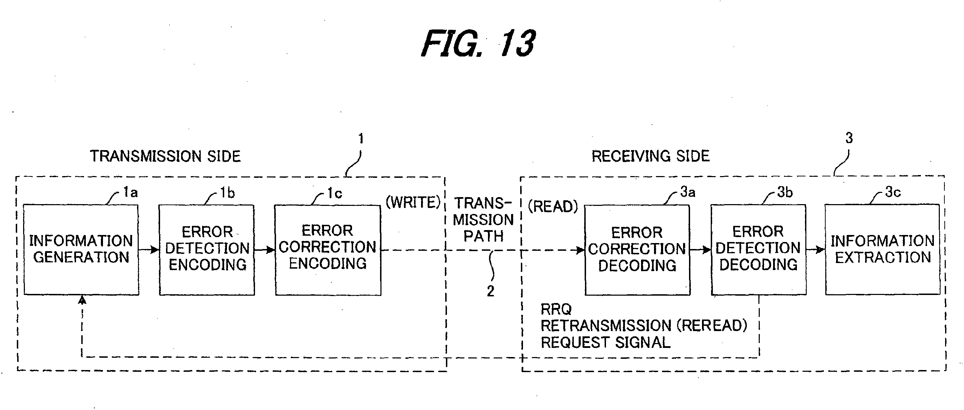

FIG. 13 shows an example of the construction of a communication system to which error detection has been applied. On the transmitting side 1, an error detection code encoding unit 1b performs a process of error detection encoding on a data sequence having a specified bit length that was generated by an information generation unit 1a, and an error correction code encoding unit 1c performs a process of error correction encoding on the input data sequence using a specified encoding method, and transmits that encoded data sequence to the receiving side 3 via a transmission path 2. On the receiving side 3, an error correction decoding unit 3a decodes the input encoded data sequence by an error correction decoding process, and inputs the decoded data sequence to an error detection decoding unit 3b. The error detection decoding unit 3b detects whether or not there is any error by performing an error detection decoding process on the decoded data sequence, and when there is error, transmits a retransmission request signal to the transmitting side. When there is no error, an information extraction unit 3c extracts and outputs the data.

Cyclic redundancy check (CRC) code is able to detect continuous error, so it is often used as error detection code. On the transmitting side, N-bits of data sequence is regarded as a polynomial, that polynomial is divided by a generator polynomial, the m-bit of remainder obtained by the division is added to the N-bits of data sequence as CRC code so that the (N+m) -bits of data sequence is divisible by the generator polynomial and the (N+m) -bits of data sequence is transmitted. On the receiving side, error detection is performed by dividing the received data sequence by the aforementioned generator polynomial, and when the remainder is '0' there is no error, otherwise there is error. For example, in a case where the generator polynomial G(x) is 16 bits, and the following equation

$$x^{16}K(x) \div G(x) = Q(x), \text{ remainder } R(x)$$

is given, W(x) represented by

$$W(x) = x^{16}K(x) + R(x)$$

is defined as a CRC code word and transmitted to the receiving side. Here, $x_{16}K(x)$ is a data sequence obtained by adding 16 bits of "0s" to the lower-order side of the N-bits of data sequence K(x). On the receiving side, when W'(x) = W(x)+E(x), which is the code word W(x) to which error E(x) is added, is received, W'(x) is divided by G(x), and when the remainder is '0', there is no error, however, when the remainder is something other than '0', it is detected as error. More specifically, the operation

$$W'(x) \,/\, G(x)$$

is performed, and whether or not W'(x) is divisible is detected.

When performing CRC encoding and decoding, the division described above must be performed, however, the divider used can be constructed using hardware with relatively simple circuits. An example of the construction of a circuit for performing division by the mth degree polynomial

$$G(x) = x^m + g_{m-1}x^{m-1} + \cdots + g_1x + 1 \qquad (1)$$

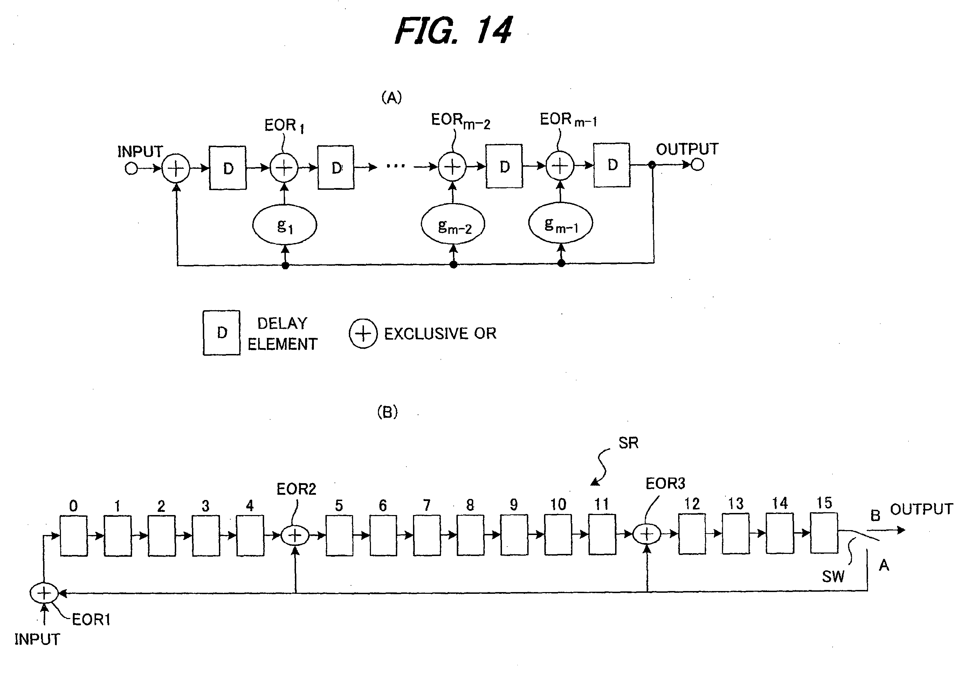

is shown in (A) of FIG. 14. In the figure, gi becomes a coefficient '0' or '1', in the case where $g_i=1$ the output terminal is connected by to EORi, and in the case where gi=0 the output terminal is not connected to EORi. An example of a divider of a CRC operation unit for the case in which the generator polynomial is G(x) $=x^{16}+x^{12}+x^5+1$, for example, is shown in (B) of FIG. 14. This divider comprises: a 16-stage shift register SR, exclusive OR circuits EOR1 to EOR3 that are provided on the input side of the 0-bit position, 5-bit position and 12-bit position and that perform an exclusive OR operation on the previous stage output data and feedback data; and a switch SW that is provided on the output side of the 15-bit position. With the switch SW switched to the feedback side (A side), division can be performed by inputting the data sequence from the higher order to EOR1 one bit at a time.

With the construction shown in (A) of FIG. 14, by inputting the coefficients of each degree of the polynomial W' (x) from the left side of the shift register in order starting from the coefficient of the highest degree, a quotient polynomial is output from the right side of the shift register, and after the coefficient of each degree has been input, the remainder polynomial is saved in the shift register. A divider can be constructed in this way with simple circuitry from a shift register and exclusive OR circuits. Incidentally, in the construction of the divider shown in FIG. 14, even if the circuitry is simplified it is necessary that the coefficient is sequentially input from a high-degree bit. Therefore, when a bit sequence that is not arranged in the proper order is input, for example, in the case of inputting a bit sequence in which the data sequence has been arranged by interleaving, the data sequence must be rearranged into the proper order using a memory or the like before being input to the divider.

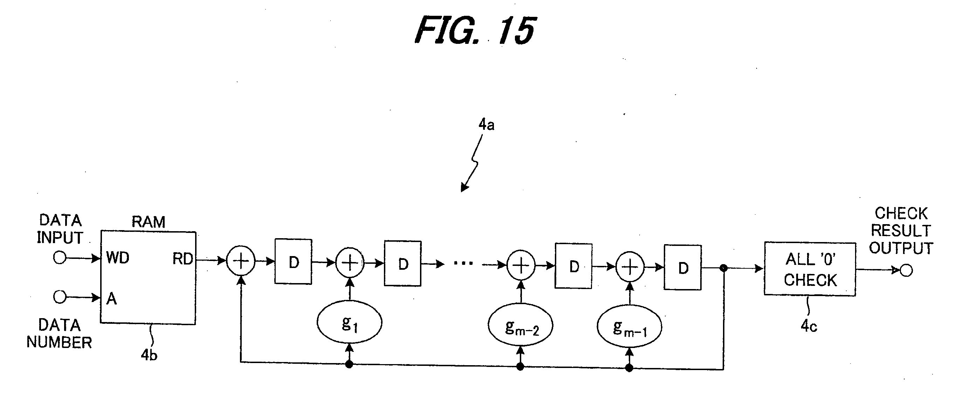

FIG. 15 is drawing showing the construction of a CRC check circuit when inputting a bit sequence that is not arranged in the proper order, where there are a RAM 4b for rearranging the data order provided in the stage before the divider 4a shown in (A) of FIG 14, and in the rear of the divider 4a an all zero detection circuit 4c that determines whether or not the remainder found by the divider 4a is '0' and outputs the check result. Together with the bit sequence (input data sequence), the proper order of each bit (data numbers) is input to the RAM 4b for rearranging the data order. By doing so, RAM 4b rearranges the bit sequence to the proper order by writing input data for each bit in the position instructed by the data number, and then reading the data in order. In other words, when a rearrangement operation such as interleaving is complex, it is necessary to store all of the input data first in memory, and then read the data in the proper order before inputting the data to the divider 4a, therefore, time is required for rearranging the data. For example, in the case of N bits of input, the CRC operation cannot start until after N clock intervals of time have elapsed, so as a result, the CRC check results cannot be obtained until 2N clock intervals of time have elapsed.

Incidentally, there is a decoder whose ability to correct error improves the more times that decoding is performed. In this kind of decoder, decoding of the input data is repeated until there is no error, and as soon as the error is gone, decoding of that data stops and decoding of the next input data begins. Such a decoder is disclosed in WO00/41312. FIG. 16 shows an example of a communication system that uses turbo code as error correction code, and uses CRC code as error detection code.

On the transmitting side 5, a CRC addition unit 5b performs a process for adding CRC code to a data sequence having a specified bit length that was generated by an information generation unit 5a, and a turbo encoding unit 5c performs a turbo encoding process on the input data sequence to which CRC code has been added and sends the result to the communication path (transmission path)6. On the receiving side 7, a turbo decoder 7a decodes the input encoded data sequence using a turbo decoding process, and inputs the decoded result to a CRC detection unit 7b.

By repeating decoding, the turbo decoder 7a can improve the error rate characteristics. In order to accomplish this, the turbo decoder 7a performs the decoding process a specified number of times, and the CRC detection unit 7b performs error detection on the decoded result, and when there is error, sends a retransmission request RRQ to the transmitting side, and when there is no error, instructs the information extraction unit 7c to extract information. Moreover, when error disappears before the decoding process has been performed the specified number of times, the decoder 7a is able to improve the efficiency of the decoding process by immediately stopping the decoding process and beginning decoding of the next encoded data sequence. In order to do this, the CRC detection unit 7b detects whether or not there is error in the decoded result after each time the decoding process is performed, and sends the error detection result as feedback to the turbo decoder 7a. The turbo decoder 7a repeats the decoding process when an error detection result indicating that there is error is inputted, however, when an error detection result indicating that there is no error is inputted, the turbo decoder 7a stops the decoding operation even though the process may not yet have been performed the specified number of times, and begins decoding the next encoded data.

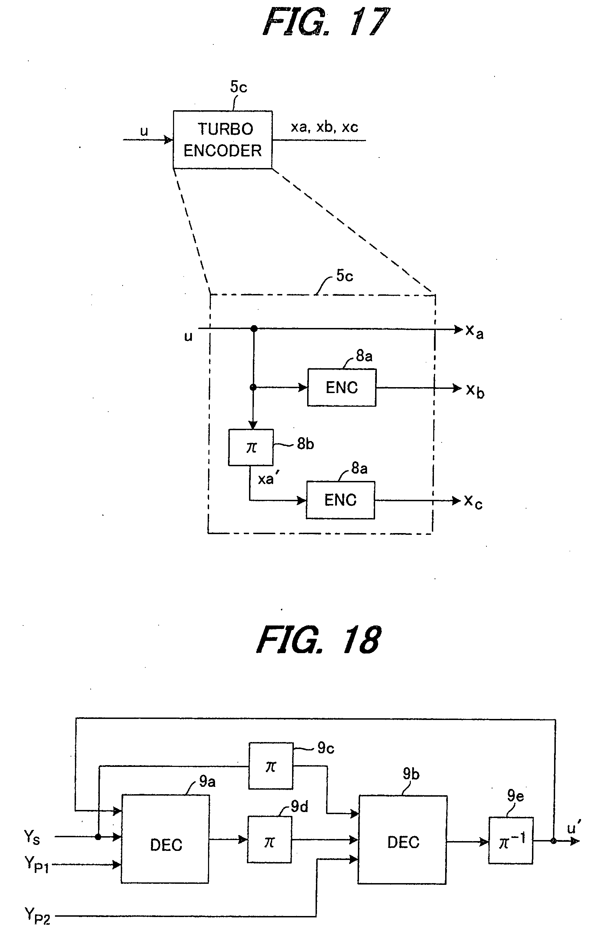

FIG. 17 is drawing showing the construction of the turbo encoder 5c, where u is N bits of input data to which CRC bits have been added, and xa, xb and xc are encoded data resulting from the turbo encoder 5c encoding the input data u. The encoded data xa is the input data u itself, the encoded data xb is the input data u that has undergone convolutional encoding by an encoder 8a, and encoded data xc is the information data u that has been interleaved (n) by an interleaver 8b and then undergone convolutional encoding by an encoder 8c. In other words, the encoded data that is output from the turbo encoder a systematic code having an encoding rate of 1/3 and comprising the input data u (=xa) to which parity bits xb, xc have been added.

FIG. 18 is a drawing of the construction of a turbo decoder 7a. The turbo decoder first uses Ys and Yp1 selected from among the received signals Ys, Yp 1 and Yp2 of the encoded data xa, xb and xc to perform decoding by a first element decoder 9a. Next, the decoder uses the decoded result (likelihood), which is output from the first element decoder 9a, and Ys and Yp2 to perform similar decoding by a second element decoder DEC9b. However, Yp2 is a received signal that corresponds to xc, which is the original data u that has been interleaved and encoded, so before being inputted to the second element decoder 9b, Ys and the likelihood that is output from the first element decoder are interleaved (n) by interleavers 9c and 9d.

After the likelihood that is outputted from the second element decoder 9b is deinterleaved ($\pi^{-1}$) by a deinterleaver 9e, it is fed back to the first element decoder 9a as input. The first element decoder 9a uses the fed back likelihood u', Ys and Yp1 to perform decoding, after which decoding is repeated by the first and second element decoders 9a, 9b until the number of times decoding has been performed reaches a specified number of times, or the decoding described above is repeated until there is no error.

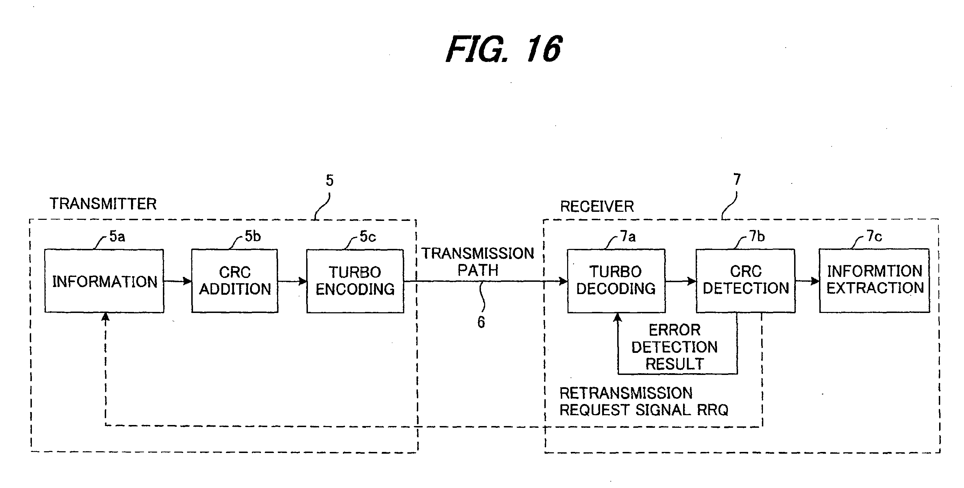

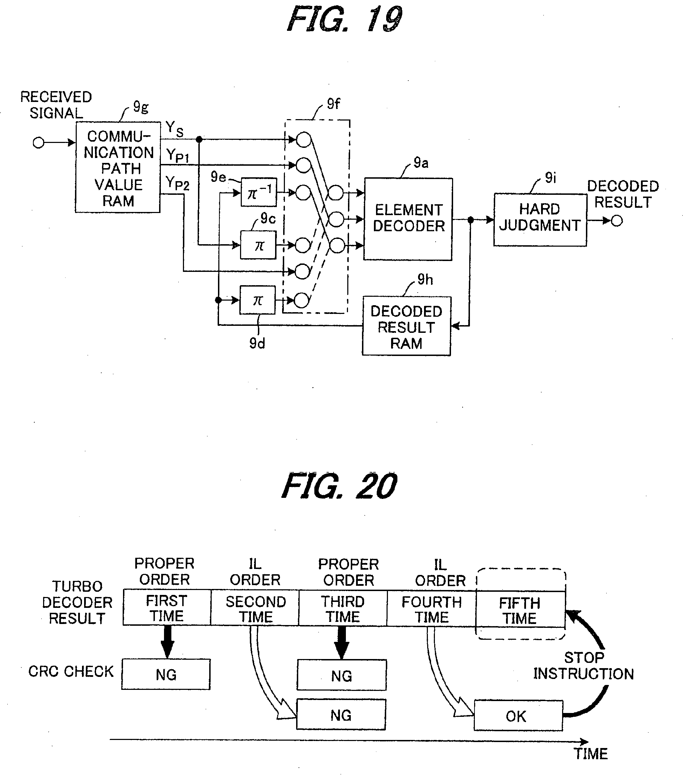

FIG. 19 is a drawing showing the construction of a turbo decoder that combines the first and second element decoders shown in FIG. 18 into one element decoder 9a, wherein a switch 9f switches the input to the element decoder 9a according to whether the decoding operation is an odd number time or even number time. A communication path value RAM 9g stores the signals Ys, Yp1, Yp2 that are received from the communication path, and together with suitably inputting these signals to the element decoder 9a via the switch 9f, inputs the signals to the interleaver 9c. A decoded result RAM 9h saves the decoded results and inputs those results to an interleaver 9d and deinterleaver 9e. A hard judgment unit 9i determines whether the decoded result is "0" or "1", and inputs the judgment result to the CRC detection unit 7b (FIG. 16).

In the turbo decoder shown in FIG. 19, first, a first decoding is performed by the connection at the switch 9f indicated by the solid line. At this time, the decoded result is output in the proper order. Next, decoding is performed with the connection at the switch 9f indicated by the dashed line. In this second decoding process, information bits Ys and the decoded result are interleaved and then decoding is performed. Here, the output of decoded result is in an interleaved order. After that, these decoding processes are repeated, and when taking a look at the decoded result, the output order after each repetition is repeated as: Proper order → Interleaved order (IL order) → Proper order → Interleaved order →...

FIG. 20 is a drawing showing the timing for acquiring the CRC check result, and shows the case in which no error is detected in the decoded result of the fourth repetition. As explained in FIG. 15, the CRC check result can be output at the same time as the time when decoding ends in a case where the input data, which is the decoded result, is in the proper order. However, when the bit sequence of the input data is interleaved, the input data must be rearranged into the proper order before performing the CRC check, so the output timing of the CRC check result is delayed. Therefore, during decoding, the number of times decoding is performed and the timing for acquiring the CRC check result are as shown in FIG. 20.

In other words, when performing a CRC check of the turbo decoding result, the data in the decoded result of an odd repetition are in the proper order, so the data can be input as is to the divider of the CRC operation unit, and the CRC check result can be output at the same time as the time when the turbo decoding ends. However, the data in the decoded result of an even repetition are in the interleaved order and the data must be rearranged into the proper order, so the decoded result must first be stored in memory before being input to the divider of the CRC operation unit, and the timing for acquiring the CRC check result is delayed. Therefore, even though error is not detected in the decoded result of the fourth repetition and the turbo operation tries to stop, the next turbo decoding (fifth repetition) is already being performed during the CRC operation, and the turbo decoder is operated excessively. In other words, the turbo decoding operation is performed one time too many, which causes a decrease in the processing efficiency of the turbo decoding process.

As related art, there is a syndrome calculating technique that is capable of properly performing syndrome calculation even though the order of data during the syndrome calculation is different from the order when the check data is created (Japanese patent publication no. H5-165660A). However, in the case where the bit sequence of input data has been interleaved by an interleave operation or the like, this related art is not a technique for quickly outputting the CRC check result without rearranging the data into the proper order.

Taking the above into consideration, when the bit sequence of input data is arranged differently from the proper order, the object of the present invention is to output the CRC check result without rearranging the data into the proper order.

Another object of the present invention is to immediately output the CRC check result at the instant when error in the decoded result disappears.

Another object of the present invention is to reduce the number of times decoding is performed by the decoder.

A further object of the present invention is to make possible the objective CRC operation device having compact hardware construction.

DISCLOSURE OF THE INVENTION

According to a first aspect of the present invention there is provided an error detection method that detects whether or not input data sequence has error wherein the input data sequence is created at an encoder by regarding a data sequence having a specified bit length as a polynomial, divides that polynomial by a polynomial for generating error detection code and adding the error detection code to the data sequence so that the remainder becomes '0', comprising steps of: calculating remainder values by dividing polynomials that correspond to each respective bit position by said generator polynomial and saving those remainder values beforehand in a memory; inputting together with an input data sequence, bit position information that indicates the proper bit position of each data of the input data sequence; finding from the memory remainder values that correspond to the proper bit positions of data of the input data sequence that are not '0'; performing bit-corresponding addition of each of the found remainder values; and determining that there is no error in the input data sequence when all of the bits of the addition result become '0', and otherwise determining that there is error; wherein calculating and saving said remainder values includes calculating and saving remainder values that correspond to every bit position at each interval of a constant number of bits, and finding remainder values comprises interpolating remainder values of the bit positions that have not been saved by using the saved remainder values, and wherein, when said interval of a constant number or bits is taken to be P, the remainder value for a bit position $n \times P + k$ ($0 \leqq k < P$) is the remainder value obtained by shifting the remainder value for the bit position $n \times P$ by k bits to the left, and dividing that shifted result by said generator polynomial.

According to a second aspect of the present invention there is provided an error detection device configured to detect whether or not input data sequence has error wherein the input data is created at an encoder by regarding a data sequence having a specified bit length as a polynomial, dividing that polynomial by a polynomial for generating error detection code and adding the error detection code to the data sequence so that the remainder becomes '0', comprising: a remainder memory configured to save remainder values that are obtained when polynomials corresponding to each respective bit position are divided by said generator polynomial an addition unit to which, together with an input data sequence, bit position information that indicates the proper bit position of each data of the input data sequence is input, which addition unit is configured to find remainder values from said remainder memory that correspond to the proper bit positions of data of the input data sequence that are not '0', and perform bit-corresponding addition of each of the found remainder valuesan error judgment unit configured to determine that there is no error in the input data sequence when all of the bits of the addition result are '0', and otherwise to determine that there is error; wherein the remainder memory is operable to save remainder values that correspond to bit positions at every interval of a constant number of bits, and the error detection device further comprises a remainder interpolation unit configured to interpolate remainder values of bit positions that are not saved using the save remainder values; and wherein, when said interval of a constant number of bits is taken to be P, said remainder interpolation unit is operable to calculate the remainder value for a bit position $n \times P + k$ ($0 \leqq k < P$) by shifting the remainder value for the bit position $n \times P$ by k bits to the left and dividing that shifted result by said generator polynomial.

"Out of Order Incremental CRC Computation" by J. Satran et al, IEEE Transactions on Computers, Vol. 54, No.9, September 2005, discloses an incremental CRC computation whereby each arriving segment contributes its share to the message's CRC upon arrival, independently of other segment arrivals.

BRIEF DESCRIPTION OF THE DRAWINGS

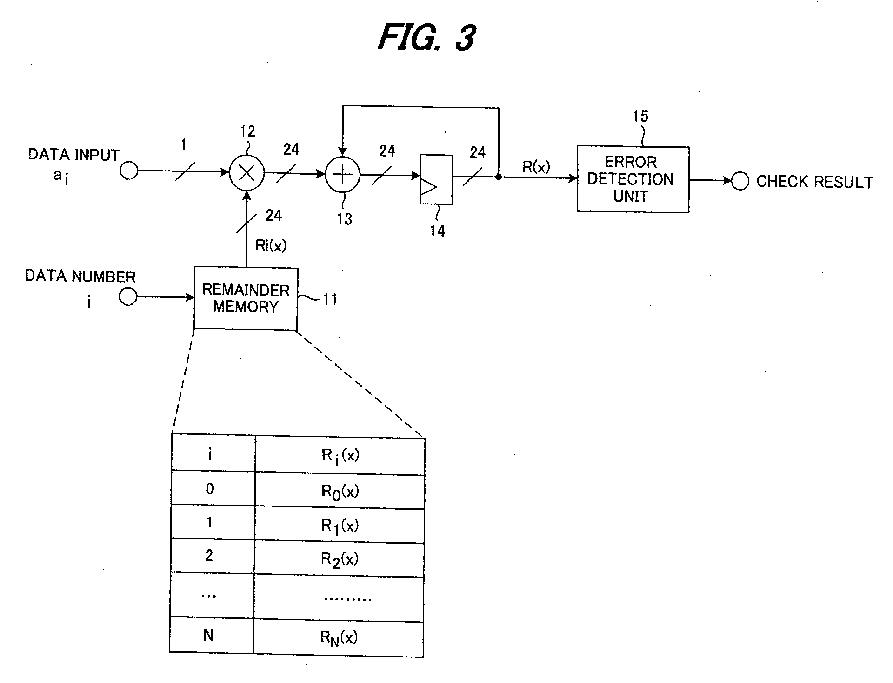

FIG. 1 is a drawing showing the theoretical construction of a CRC operation device.
FIG. 2 is a drawing explaining the timing from the start of data input to the output of the check result.
FIG. 3 is a drawing showing the construction of a first device which does not embody the present invention, but is useful for understanding it.
FIG. 4 is a drawing explaining the relationship between the bit number i and P and k of an embodiment of the present invention.
FIG. 5 is a drawing explaining the contents of a remainder memory of the embodiment.
FIG. 6 is a drawing showing the construction of a CRC operation unit of the embodiment.
FIG. 7 is a drawing explaining the number of input bits and the number of output bits of each portion of a remainder value interpolation unit.
FIG. 8 is a drawing explaining the construction of a remainder calculation unit.
FIG. 9 is a drawing of a second device which does not embody the present invention, wherein the CRC operation

**EP 2 187 525 B1**

device of Fig. 3 is used for error detection of a turbo decoding result.

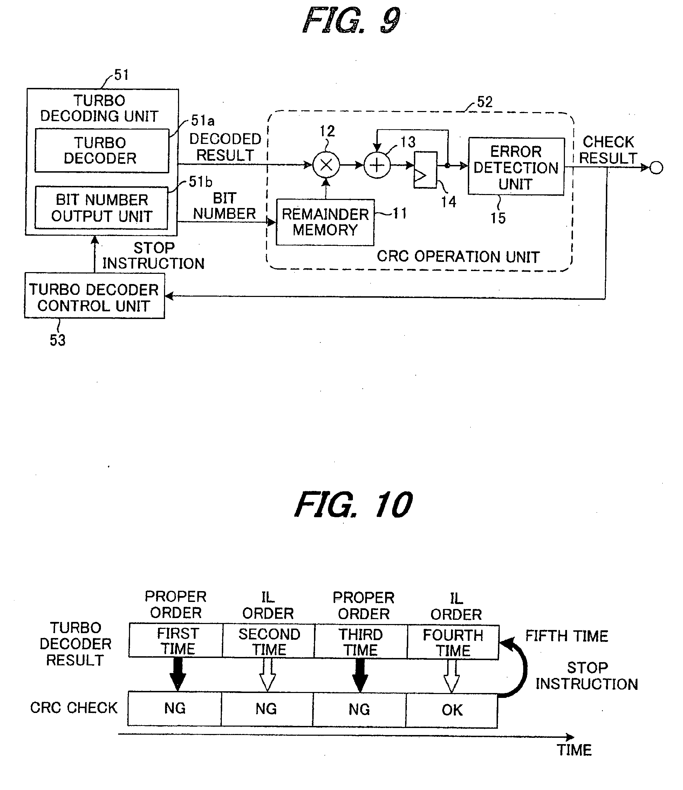

FIG. 10 is a drawing that shows the output timings of the decoded result from the turbo decoder and the CRC check result of the device of Fig. 9.

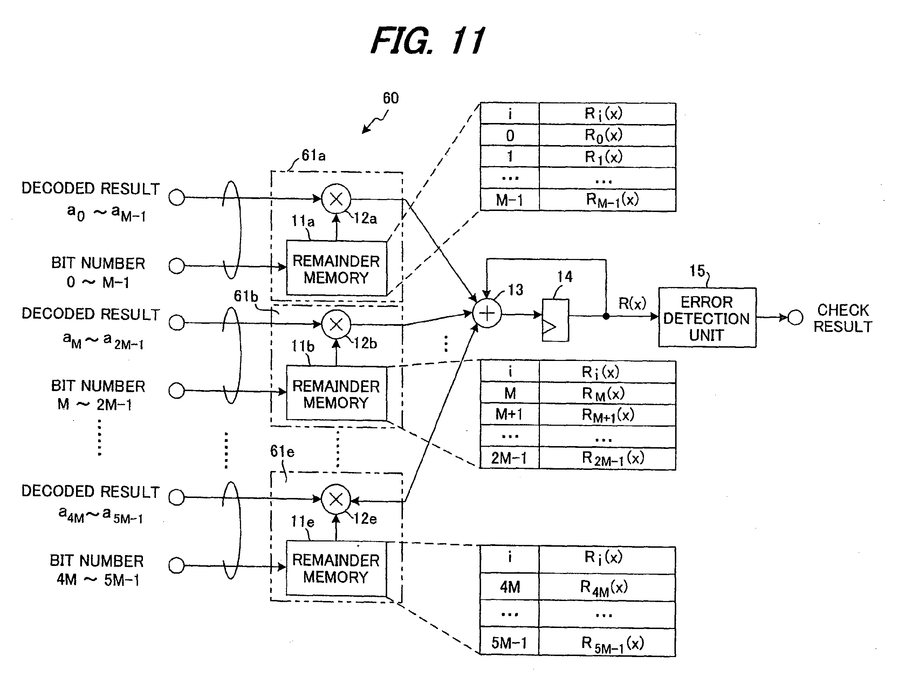

FIG. 11 is a drawing showing the construction of a CRC check device of a third example which does not embody the present invention.

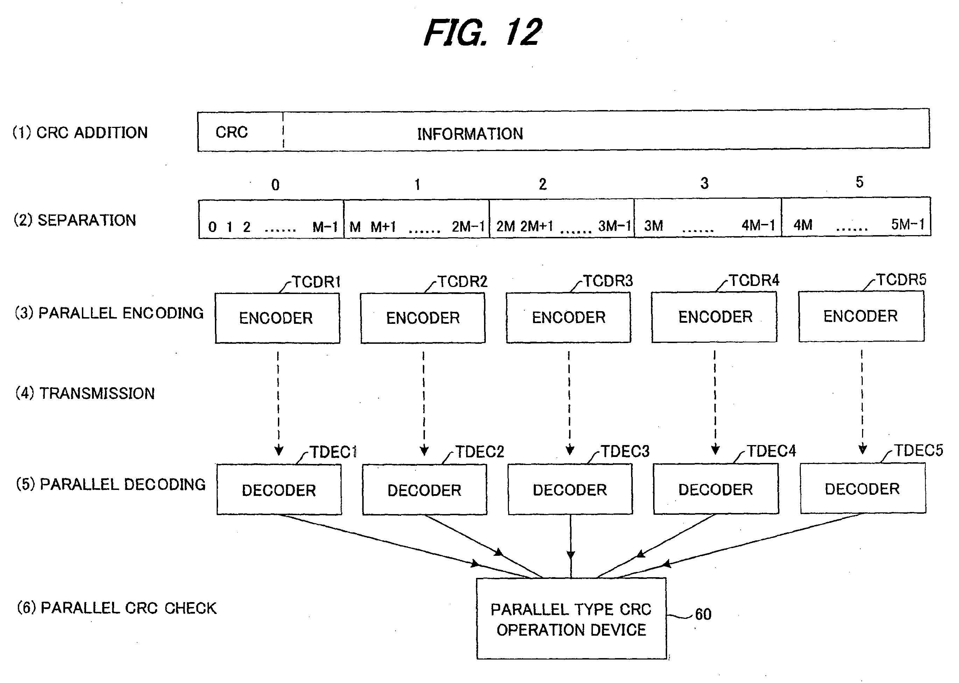

FIG. 12 is a drawing explaining the case where input bit sequences are input in parallel.

FIG. 13 is an example of the construction of a communication system to which error detection is applied.

FIG. 14 is an example of the construction of a divider circuit.

FIG. 15 is a drawing showing the construction of a CRC check circuit when a bit sequence is input that is not arranged in the proper order.

FIG. 16 is an example of a communication system that adopts the use of turbo code for error correction code, and uses CRC code for error detection code.

FIG. 17 is a drawing showing the construction of a turbo encoder.

FIG. 18 is a drawing showing the construction of a turbo decoder.

FIG. 19 is a drawing showing the construction of a turbo decoder that combines a first and second element decoder into one element decoder.

FIG. 20 is a drawing explaining the number of times decoding has been performed and the timing for acquiring the CRC check result.

BEST MODE FOR CARRYING OUT THE INVENTION

(A) Theory of the Invention

The present invention makes it possible to perform CRC operation on data of which bit sequence is arranged differently from the proper order without returning to the proper order. For example, in the CRC operation method in the case of data that have been input in an order that has been randomized by an interleaving process or the like, the present invention makes it possible to quickly output an error detection result by performing CRC operation without rearrangement processing. All of the operations described below are for "bit-corresponding modulo 2 operation" where "bit-corresponding operation" is operation performed for bits at the same bit location, and modulo 2 addition uses the operator "+". More specifically, modulo 2 addition is an exclusive OR operation, so bit-corresponding modulo 2 addition is an exclusive OR operation for bits at the same bit location. Also, the "+" operation symbol that appears in the figures showing circuit configuration similarly indicates a bit-corresponding exclusive OR operation.

In the remainder operation that is used for the CRC operation the input data expressed by a polynomial A(x), and the remainder is obtained by dividing A(x) by an m-degree generator polynomial G(x).

An input bit sequence having N bits

$$\{a_{N-1}, a_{N-2}, \cdots, a_1, a_0\}$$

is expressed as the following polynomial.

$$A(x) = a_{N-1}x^{N-1} + a_{N-2}x^{N-2} + \cdots + a_1 x + a_0 = \sum_{i=0}^{N-1} a_i x^i \qquad (2)$$

In addition the m-degree generator polynomial is expressed as below.

$$G(x) = x^m + g_{m-1}x^{m-1} + \cdots + g_1 x + 1 \qquad (3)$$

The remainder $R_i(x)$ that is obtained by dividing polynomial $x^i$ that corresponds to the ith bit position of the input bit sequence by G(x) can be expressed as the following.

6

$$x^i = R_i(x) + Q_i(x)G(x) \qquad (4)$$

Here, $x^i$ indicates a bits-sequence (polynomial) which is created by adding i number of "0s" after a 1. Moreover, $Q_i(x)$ is a quotient polynomial resulting from dividing $x^i$ by $G(x)$. From this, $A(x)$ can be rewritten as below.

$$A(x) = \sum_{i=0}^{N-1} a_i \left( R_i(x) + Q_i(x)G(x) \right)$$
$$= \sum_{i=0}^{N-1} a_i R_i(x) + G(x) \sum_{i=0}^{N-1} a_i Q_i(x) \qquad (5)$$

The second item on the right side of Equation (5) is divisible by the generator polynomial $G(x)$, so the remainder $R(x)$ resulting from dividing $A(x)$ by $G(x)$ is the remainder obtained by dividing the first item on the right side of Equation (5) by $G(x)$, and since the first item is not divisible by $G(x)$, $R(x)$ becomes as given below.

$$R(x) = \sum_{i=0}^{N-1} a_i R_i(x) \qquad (6)$$

Therefore, by knowing $R_i(x)$ in advance, the value of the remainder $R(x)$ can be calculated by calculating $a_i R_i(x)$ and finding the total sum of the results for all of the bits, regardless of the order of the input.

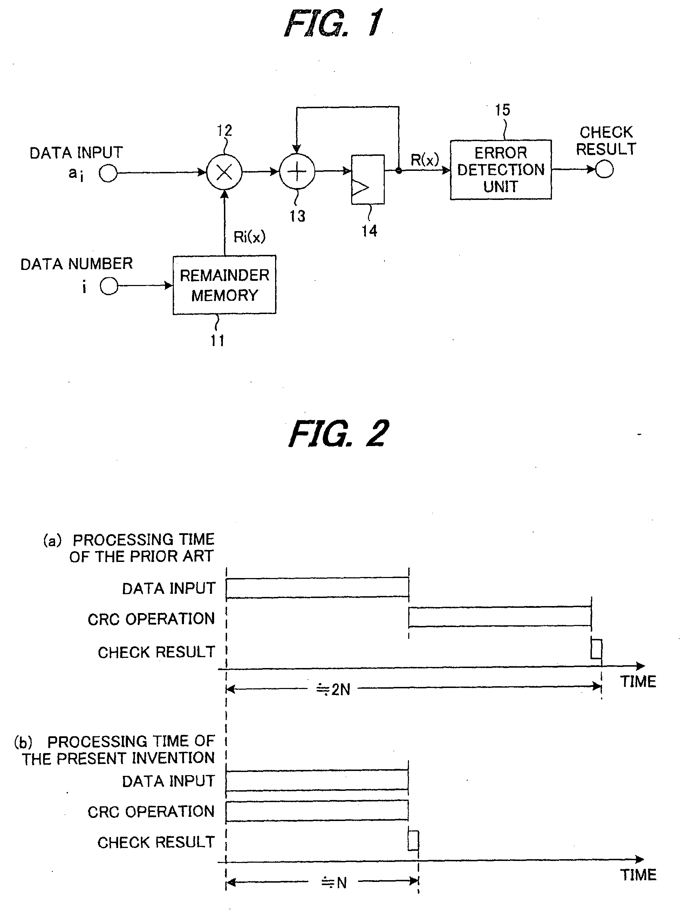

FIG. 1 is a drawing showing the construction of a CRC operation device that corresponds to the theory described above, where bit data $a_i$ is input to the CRC operation device 1 bit at a time together with bit position information (data number) that indicates the proper bit position i of that bit data. A remainder memory 11 correlates the m bit of remainder $R_i(x)$, which is obtained in advance by dividing $x^i$ by the generator polynomial $G(x)$, with the bit position i (i = 0 to N, N+1 is the number of bits in the input data sequence), and stores that correlation, and when bit position information i is input, outputs the remainder $R_i(x)$ that corresponds to that bit position. A multiplier 12 outputs the remainder $R_i(x)$ as is when $a_i$ is "1", and outputs m bits of 0s when $a_i$ is "0". An adder 13 performs bit-corresponding modulo 2 addition (exclusive OR operation) of the addition results up to that point (initial value is m bits of 0s) and the output from the multiplier 12, and saves the addition result in a register 14. After that, the process described above is repeated for all of the bits of input data, and the last modulo 2 addition result is output as the remainder $R(x)$. An error detection unit 15 determines that there are no errors in the input data when all of the bits of the remainder $R(x)$ are "0", otherwise determines that there is error and outputs the judgment results.

By doing the above, it becomes possible to output CRC check results at nearly the same time as the time when the input of N+1 bits of data is complete even when the input order is not in the proper order. And in regards to the time from when data input starts to when the check result is output, it takes conventionally a time of $2 \times N$ as shown in (a) of FIG. 2, but it takes only a time of N as shown in (b) in the present invention. Therefore, it is possible to output the CRC check results immediately every time turbo decoding is repeated and finished, and when there is no error in the decoded result, it becomes possible to immediately stop the turbo decoder, so there is no need for unnecessary decoder operation.

(B) First Example

FIG. 3 is a drawing showing the construction of a first example, which does not embody the present invention, where the same reference numbers are given to parts that are identical to those in FIG. 1. This drawing differs in that the contents of the remainder memory 11 are clearly shown, the number of input bits and output bits at each unit 11 to 15 is shown, and the number of bits m of the remainder $R_i(x)$ is 24 bits.

The values of the remainder $R(x)$ are stored in a remainder memory 11 beforehand as a table of $R_i(x)$ values that are computed from the right side of Equation (6). Input data $a_i$ is input together with the data number i, and the remainder $R_i(x)$ is obtained by referencing the ROM table according to the data number i. The obtained $R_i(x)$ is multiplied by the input data $a_i$, and the multiplication result is added to the addition result (initial value is m bits of 0s) up to that point that has been saved in a register 14. Here, bit-corresponding modulo 2 addition is performed as the addition operation. By performing the operation described above for all bits, the value of the remainder $R(x)$ is found after data input is complete. An error detection unit 15 determines whether the remainder $R(x)$ is 0, and when it is 0, outputs a check result of "OK", however, when it is something other than 0, outputs a check result of "NG".

In other words, according to this first example; (1) each data $a_i$ of an input data sequence is input together with bit position information i that indicates the proper bit position of each data; (2) the CRC operation device finds the value of the remainder $R_i(x)$ that corresponds to the proper bit position i of each data of the input data sequence that is not 0, and performs bit-corresponding modulo 2 addition of each of the found remainder values $Ri(x)$; and (3) taking the addition result to be the remainder value $R(x)$, determines that there is no error in the input data sequence when all of the bits of the remainder value $R(x)$ are 0, otherwise determines that there is error. In this way, with this first example, the CRC check result can be output immediately every time turbo decoding is repeated and finished.

(C) Embodiment

In the first example, it was necessary to store a remainder value $R_i(x)$ for each bit of a maximum bit length N+1 of input data, so when N is large, for example when N = 10,000, there is a problem in that the remainder memory 11 becomes large. Therefore, in an embodiment of the invention, the size of the remainder memory 11 can be reduced by storing a remainder value in the remainder memory 11 after every P bits.

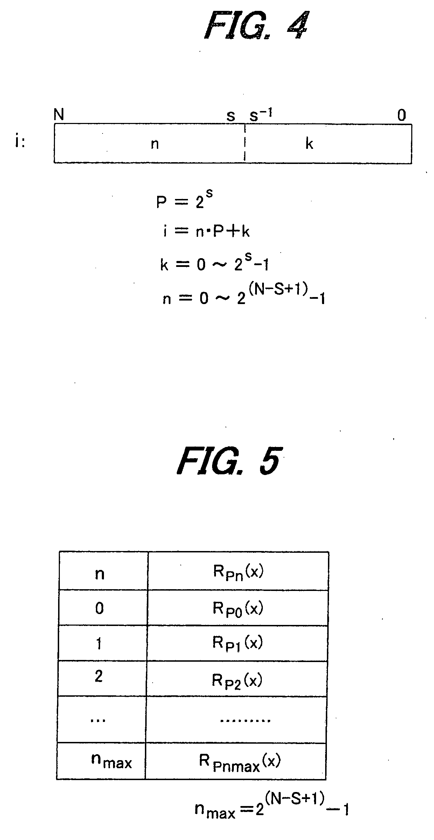

With P taken to be an arbitrary constant, then as shown in FIG. 4, i, which indicates the bit position, is decomposed as in Equation (7) where $P = 2^s$.

$$i = P \cdot n + k, 0 \le k \le P - 1 \qquad (7)$$

Here, the necessary remainder value $R_i(x)$ is the remainder obtained by dividing $x^i$ by the generator polynomial $G(x)$. When the quotient polynomial obtained by dividing $x^{Pn}$ by the generator polynomial $G(x)$ is expressed as $Q_{Pn}(x)$, and the remainder polynomial is expressed as $R_{Pn}(x)$, then $x^i$ is given by the following equation,

$$\begin{aligned} x^i &= x^{Pn+k} \\ &= x^{Pn} \cdot x^k \\ &= \left( Q_{Pn}(x) G(x) + R_{Pn}(x) \right) x^k \end{aligned} \qquad (8)$$

so the remainder value $R_i(x)$ becomes equal to the remainder obtained by dividing $R_{Pn}(x) \cdot x^k$ by $G(x)$. Therefore, as shown in FIG. 5, $R_{Pn}(x)$ are correlated to a bit position n every P bits and stored as a table, and a remainder is found by finding $R_{Pn}(x)$ that corresponds to n of bit position i (i = P $\cdot$ n+k) and multiplying it by $x^k$, then dividing the multiplication result $R_{Pn}(x) \cdot x^k$ by $G(x)$, and that remainder is taken to be the remainder value $Ri(x)$. $R_{Pn}(x) \cdot x^k$ is computed by performing an operation of shifting $R_{Pn}(x)$ that is obtained from the table by k bits to the left, and inserting 0 into the empty bits.

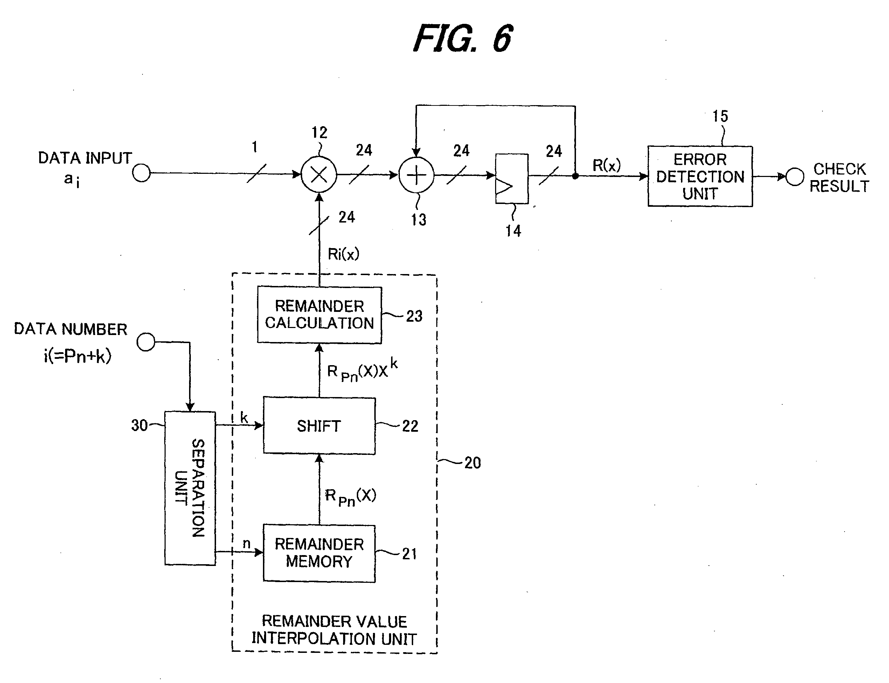

FIG. 6 is a drawing showing the construction of a CRC operation device of an embodiment according to the theory described above, where the same reference numbers are given to parts that are identical to those shown in FIG. 1. This embodiment differs from the first example in that remainder values $R_{Pn}(x)$ that correspond to bit positions P $\times$ n every constant P bits are saved, and a remainder value interpolation unit 20 is provided that interpolates the remainder values for bit positions that are not saved by using the saved values, and a separation unit 30 is provided into which bit positions i (i = P $\cdot$ n+k) are input and it separates the bit positions i into P and k.

The remainder value interpolation unit 20 comprises: a remainder memory 21 that saves remainder values $R_{Pn}$ (x) that correspond to the bit positions P $\times$ n every constant P bits; a shifting unit 22 that shifts the $R_{Pn}(x)$ that corresponds to n of bit position i (i = P $\cdot$ n+k) by k bits to the left; and a remainder calculation unit 23 that divides $RPn(x) \cdot x^k$, which is obtained by shifting, by the generator polynomial $G(x)$, and outputs the remainder $R_i(x)$. Together with bit data $a_i$ being input 1 bit at a time, bit position information (data number) that indicates the proper bit position i (=P $\cdot$ n+k) of that bit data is input to the CRC operation device. The separation unit 30 separates the bit position i into n and k, and the remainder memory 21 outputs the remainder $R_{Pn}(x)$ that corresponds to n. The shifting unit 22 shifts $R_{Pn}(x)$ by k bits to the left and performs the operation $R_{Pn}(x) \cdot x^k$, then the remainder calculation unit 23 divides $R_{Pn}(x) \cdot x^k$ by the generator polynomial $G(x)$ and outputs the remainder $R_i(x)$.

When $a_i$ is "1", a multiplier 12 outputs the remainder $R_i(x)$ as is, and when $a_i$ is "0", outputs m bits of 0s. An addition unit 13 performs bit-corresponding modulo 2 addition of the addition result (the initial result is m bits of 0s) up to that point that is saved in a register 14 and the output of the multiplication unit 12, and saves the addition result in the register 14. After that, the process described above is repeated for all of the bits of the input data, and the final modulo 2 addition result is output as the remainder R(x). An error detection unit 15 determines that there is no error in the input data sequence when all of the bits of the remainder R(x) are "0", otherwise determines that there is error and outputs the judgment result.

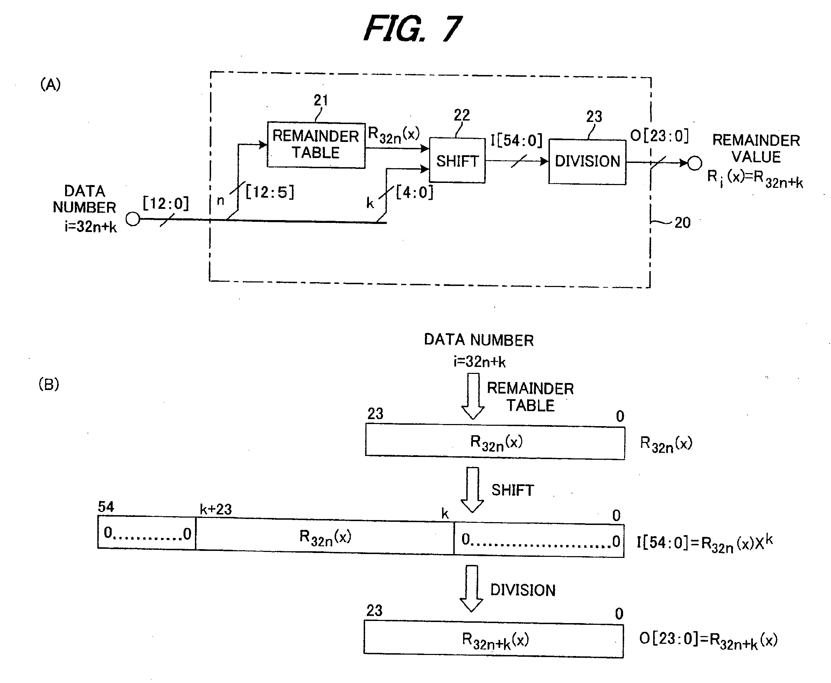

When taking the remainder value to be m bits, the shifting operation result becomes a maximum of m+P-1 bits, and when m=24 and P=32 ($2^6$), the shifting operation result becomes 55 bits. In (A) and (B) of FIG. 7, the number of input bits and the number of output bits of each portion of the remainder value interpolation unit 20 are clearly shown for the case in which m=24, P=32 ($2^6$), s =6 and N=12, where k is expressed as five bits 0 to 4, and n is expressed as eight bits 5 to 12. The remainder memory 21 correlates the 24-bit $R_{Pn}(x)$ (=$R_{32n}(x)$) with n, and stores that correlation. The output I from the shifting unit 22 is 55 bits 0 to 54, and the output $R_i(x)$ (=$R_{Pn+k}(x)$) from the remainder calculation unit 23 is 24 bits.

When the remainder calculation unit 23 in FIG. 6 and (A) of FIG. 7 comprises a shifting register (divider) as explained using FIG. 14, it is not preferred that 55 clock units be required for division. Incidentally, the number of bits of input I of the remainder calculation unit 23 is set at 55. Therefore, dividing the input I by G(x) can be considered to be division of a fixed input bit length, and the remainder calculation unit 23 can be realized by a unique fixed circuit which is consisted of only exclusive OR circuit without the use of a shifting register. For example, when the generator polynomial is taken to be

$$G(x) = x^{24} + x^{23} + x^6 + x^5 + x + 1 \qquad (9)$$

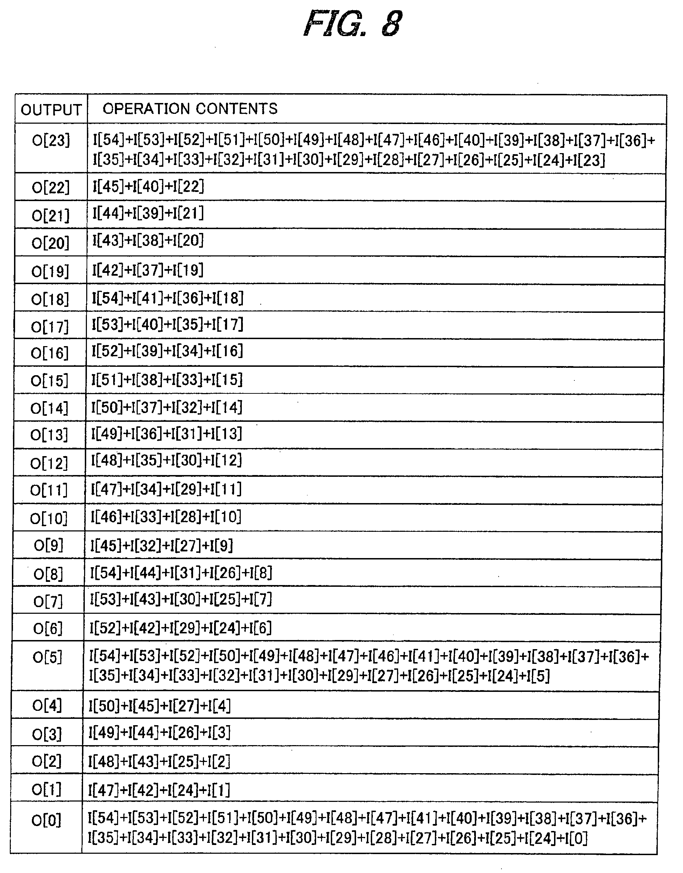

and P=32, the output bits O[0] to O[23] from the remainder calculation unit 23 can be found from an exclusive OR operation of a specified combination of input bits I[0] to I[54] as shown in FIG. 8. As an example, O[22] can be found from the exclusive OR operation of I[45], I[40] and I[22].

With this embodiment, similar to the first example, the CRC check result can be output immediately every time turbo decoding is repeated and finished, and the capacity of the remainder memory can also be reduced.

(D) Second Example

FIG. 9 shows the construction of a second example in which the CRC operation device of the first example is used for error detection of a turbo decoding result. In addition to the turbo decoder 51a that was explained using FIG. 19, a turbo decoding unit 51 comprises a bit number output unit 51b that outputs a bit number that indicates the proper bit position of each bit of the decoded result. When the decoded result is in the proper order, the bit number output unit 51b outputs bit numbers in that proper order, however, when the decoded result is in an interleaved order, outputs bit numbers in that interleaved order. A CRC operation unit 52 that comprises the construction of the first example shown in FIG. 3 and to which decoded results and bit numbers from the turbo decoder 51a and bit number output nit 51b are respectively input, checks whether or not error is contained in the turbo decoded results, and outputs check results. When the check results from the CRC operation unit 52 indicates that there is "no error" even before the set number of decoding repetitions has been reached, a turbo decoder control unit 53 causes the turbo decoder 51a to stop turbo decoding, and to start decoding the next encoded data. It is also possible to use the construction of the embodiment shown in FIG. 6 as the CRC operation device 52.

FIG. 10 is a drawing explaining the output timing of the decoded result from the turbo decoder and output timing of the CRC check result in this second example, and shows the case when error has disappeared after the fourth decoding repetition (CRC OK). With this second example, the CRC operation device 52 is able to perform the CRC operation as the turbo decoder 51a inputs the decoded results one bit at a time, so, in other words, the CRC operation device 52 can perform the CRC operation while the turbo decoder 51a performs turbo decoding. Therefore, after the turbo decoder 51a has repeated and finished turbo decoding operation, the CRC operation device 52 immediately can output the CRC check result for that decoding result, and as soon as a CRC OK is detected, the turbo decoder control unit 53 can send a stop instruction to the turbo decoder 51 and stop the turbo decoding operation. As a result, the turbo decoder 51a does not need to perform unnecessary repetitions, and can start the decoding operation for the next encoded data.

When referencing the decoded result of the third timing shown in FIG. 20, in this example of prior art, the CRC check operation in the interleaved order of the second time, and the CRC check operation in the proper order of the third time must be performed at the same time. Therefore, in this example of prior art, in order that the CRC operation can be performed at the same time, mounting two CRC operation devices can be supposed. However, with this second example, it is possible to perform the CRC operation on the turbo decoded results using only one CRC operation device, and thus it is possible to reduce the number of mounted CRC operation devices.

(E) Third Example

FIG. 11 is a drawing of the construction of a CRC operation device of a third example of the invention, and comprises construction for calculating the remainder $R_i(x)$ for each parallel input data in the case where input bit sequences are input in parallel. The same reference numbers are given to parts that are identical to those shown in FIG. 3.

FIG. 12 is a drawing explaining the case when input bit sequences are input in parallel to the CRC operation device. On the transmission side, a CRC bit is added to the transmission information, and information to which CRC bits are added are separated into a plurality of blocks (five blocks in the figure), after which turbo encoding is performed, for example by turbo encoders TCDR1 to TCDR5, for each separated block, and then each block is transmitted. The information length is taken to be 5xM bits, and is separated as 0 to M-1, M to 2M-1, 2M to 3M-1, 3M to 4M-1, and 4M to 5M-1.

Turbo decoders TDEC1 to TDEC5 on the receiving side perform turbo decoding of each of the received encoded data, and input the decoded results in parallel to a parallel type CRC operation device 60 as shown in FIG. 12. The CRC operation device 60 comprises the construction shown in FIG. 11, and performs the remainder calculation of the first embodiment, for example, on each of the respective M bits of data that were input in parallel, calculates the remainder value R(x) for 5xM bits using the remainder values obtained for each of the parallel data, checks whether that remainder value R(x) is 0, and outputs the check result.

In FIG. 11, the M bits of decoded results and bit numbers that were output from each of the turbo decoders TDEC1 to TDEC5 are input to first thru fifth remainder calculation units 61a, 61b, ... , 61e in the proper order or an interleaved order. For example, M bits of the decoded result $a_0$ to $a_{M-1}$ are input in the proper order or interleaved order, and together with those decoded result bits, the bit numbers 0 to M-1 indicating the proper bit positions are input to the first remainder calculation unit 61a. In addition, M bits of the decoded result $a_M$ to $a_{2M-1}$ are input in the proper order or interleaved order, and together with those decoded result bits, the bit numbers M to 2M-1 indicating the proper bit positions are input to the second remainder calculation unit 61b. Similarly, M bits of the decoded result $a_{4M}$ to $a_{5M-1}$ are input in the proper order or interleaved order, and together with those decoded result bits, the bit numbers 4M to 5M-1 indicating the proper bit positions are input to the fifth remainder calculation unit 61e.

The remainder calculation units 61a, 61b, ..., 61e correspond to the remainder memory 11 and multiplication unit 12 in the first example shown in FIG. 3, where remainders $R_i(x)$ that are correlated with the bit positions are stored in each remainder memory unit 11a to 11e. In other words, remainders Ro(x) to $R_{M-1}(x)$ are correlated with the bit positions i = 0 to M-1 and stored in the remainder memory 11a, remainders $R_M(x)$ to $R_{2M-1}(x)$ are correlated with the bit positions i = M to 2M-1 and stored in the remainder memory 11b, and thereafter similarly, remainders $R_{4M}(x)$ to $R_{5M-1}(x)$ are correlated with the bit positions i = 4M to 5M-1 and stored in the remainder memory 11e. Each remainder memory 11a to 11e outputs remainders that correspond to the input bit positions. Multiplication units 12a to 12e multiply the respectively input decoded result bits by the remainder values that are input from the remainder memories 11a to 11e, and input the result to an addition unit 13. Overall, the 5-bit remainders are input together to the addition unit 13 from the multiplication units 12a to 12e. The addition unit 13 performs bit-corresponding modulo 2 addition of the addition result up to that point (saved in a register 14; initial value 0) and the output from the multipliers 12a to 12e, and saves that addition result in the register 14. After that, the addition unit 13 repeats the processing described for the M bits of input data, and outputs the final modulo 2 addition result as the remainder R(x). An error detection unit 15 determines that there is no error in the input data sequence when all of the bits of the remainder R(x) are '0', otherwise determines that there is error, and outputs the judgment result. In FIG. 11, the construction is based on that of the CRC operation device of the first example shown in FIG. 3, however, it is also possible to base the construction on the CRC operation device of the embodiment shown in FIG. 6.

To summarize, the CRC operation device 60 is such that when decoded results are input in parallel, the remainder values that correspond to the proper bit positions of the bit data of the parallel data sequences that are not '0' are all added by modulo addition by the adder 13, and when all of the bits of the addition result become '0', determines that there is no error in the input data sequence, otherwise determines there is error, and outputs the check result.

- Advantages of the Invention

With the present invention, even when the bit sequence of the input data is not arranged in proper order, the CRC check result can be computed and output without rearranging the data into the proper order). In addition, with the present invention, the CRC check result can be output immediately at the instant when error in the decoded result is eliminated. Moreover, with the present invention, the decoding operation can be stopped and decoding of the next encoded data can be started immediately at the instant when error in the decoded result is eliminated, and thus the number of times decoding must be performed by a decoder for one sequence of encoded data can be reduced. Furthermore, with the present invention, a CRC operation device could be constructed with small-scale hardware configuration.

**EP 2 187 525 B1**

**Claims**

1.  An error detection method that detects whether or not input data sequence has error wherein the input data sequence is created at an encoder by regarding a data sequence having a specified bit length as a polynomial, divides that polynomial by a polynomial for generating error detection code and adding the error detection code to the data sequence so that the remainder becomes '0', comprising steps of:

    calculating remainder values by dividing polynomials that correspond to a respective bit position by said generator polynomial and saving those remainder values beforehand in a memory (11, 21);
    inputting together with an input data sequence, bit position information that indicates the proper bit position of each data of the input data sequence;
    finding from the memory remainder values that correspond to the proper bit positions of data of the input data sequence that are not '0';
    performing bit-corresponding addition of each of the found remainder values; and
    determining that there is no error in the input data sequence when all of the bits of the addition result become '0', and otherwise determining that there is error; **characterised by**:

    wherein calculating and saving said remainder values includes calculating and saving remainder values that correspond to every bit position at each interval of a constant number of bits, and
    finding remainder values comprises interpolating remainder values of the bit positions that have not been saved by using the saved remainder values, and

    wherein, when said interval of a constant number of bits is taken to be P, the remainder value for a bit position n × P + k (0≦k < P) is the remainder value obtained by shifting the remainder value for the bit position n × P by k bits to the left, and dividing that shifted result by said generator polynomial.

2.  An error detection device configured to detect whether or not input data sequence has error wherein the input data is created at an encoder by regarding a data sequence having a specified bit length as a polynomial, dividing that polynomial by a polynomial for generating error detection code and adding the error detection code to the data sequence so that the remainder becomes '0', comprising:

    a remainder memory (11, 21) configured to save remainder values that are obtained when polynomials corresponding to a respective bit position are divided by said generator polynomial;
    an addition unit (12, 13, 14) to which, together with an input data sequence, bit position information that indicates the proper bit position of each data of the input data sequence is input, which addition unit is configured to find remainder values from said remainder memory that correspond to the proper bit positions of data of the input data sequence that are not '0', and perform bit-corresponding addition of each of the found remainder values;
    an error judgment unit (15) configured to determine that there is no error in the input data sequence when all of the bits of the addition result are '0', and otherwise to determine that there is error; **characterised by**:

    wherein the remainder memory (11, 21) is operable to save remainder values that correspond to bit positions at every interval of a constant number of bits, and the error detection device further comprises a remainder interpolation unit (22, 23, 24) configured to interpolate remainder values of bit positions that are not saved using the save remainder values; and
    wherein, when said interval of a constant number of bits is taken to be P, said remainder interpolation unit is operable to calculate the remainder value for a bit position n × P + k (0≦k < P) by shifting the remainder value for the bit position n × P by k bits to the left and dividing that shifted result by said generator polynomial.

**Patentansprüche**

1.  Fehlererkennungsverfahren, das erkennt, ob eine Eingabedatenfolge einen Fehler aufweist oder nicht, wobei die Eingabedatenfolge an einem Codierer erzeugt wird, indem eine Datenfolge, die eine angegebene Bitlänge aufweist, als ein Polynom betrachtet wird, das Polynom durch ein Polynom zum Erzeugen eines Fehlererkennungscodes teilt und den Fehlererkennungscode derart zu der Datenfolge addiert, dass der Rest "0" wird, und das die folgenden Schritte umfasst:

    Berechnen von Restwerten durch Teilen von Polynomen, die einer entsprechenden Bitposition entsprechen,

EP 2 187 525 B1

durch das Erzeugerpolynom und Speichern dieser Restwerte im Voraus in einem Speicher (11, 21);
Eingeben von Bitpositionsinformationen, die die richtige Bitposition von sämtlichen Daten der Eingabedatenfolge angeben, gemeinsam mit einer Eingabedatenfolge;
Finden von Restwerten, die den richtigen Bitpositionen von Daten der Eingabedatenfolge entsprechen, die nicht "0" sind, von dem Speicher;
Durchführen einer Bit entsprechenden Addition von jedem der gefundenen Restwerte; und
Bestimmen, dass kein Fehler in der Eingabedatenfolge vorliegt, wenn alle der Bits des Additionsergebnisses "0" werden, und anderenfalls Bestimmen, dass ein Fehler vorliegt;
**dadurch gekennzeichnet, dass**:

das Berechnen und Speichern der Restwerte das Berechnen und Speichern von Restwerten umfasst, die jeder Bitposition an jedem Intervall einer konstanten Anzahl von Bits entsprechen, und
Finden von Restwerten, das das Interpolieren von Restwerten der Bitpositionen, die nicht gespeichert wurden, unter Verwendung der gespeicherten Restwerte umfasst; und

wobei, wenn das Intervall einer konstanten Anzahl von Bits als P genommen wird,
der Restwert für eine Bitposition $n \times P + k$ ($0 \leqq k < P$) der Restwert ist, der durch Verschieben des Restwerts für die Bitposition $n \times P$ um k Bit nach links und Teilen dieses verschobenen Ergebnisses durch das Generatorpolynom erhalten wird.

2. Fehlererkennungsvorrichtung, die konfiguriert ist, um zu erkennen, ob eine Eingabedatenfolge einen Fehler aufweist, wobei die Eingabedaten an einem Codierer erzeugt werden, indem eine Datenfolge, die eine angegebene Bitlänge aufweist, als ein Polynom betrachtet wird, das Polynom durch ein Polynom zum Erzeugen eines Fehlererkennungscodes geteilt wird und der Fehlererkennungscode derart zu der Datenfolge addiert wird, dass der Rest "0" wird, und Folgendes umfasst:

einen Restspeicher (11, 21), der konfiguriert ist, um Restwerte zu speichern, die erhalten werden, wenn Polynome, die einer jeweiligen Bitposition entsprechen, durch das Generatorpolynom geteilt werden;
eine Additionseinheit (12, 13, 14), in die gemeinsam mit einer Eingangsdatenfolge Bitpositionsinformationen eingegeben werden, die die richtige Bitposition von sämtlichen Daten der Eingabedatenfolge angeben, wobei die Additionseinheit konfiguriert ist, um Restwerte von dem Restspeicher zu finden, die den richtigen Bitpositionen von Daten der Eingabedatenfolge entsprechen, die nicht "0" sind, und eine Bit entsprechende Addition von jedem der gefundenen Restwerte durchzuführen;
eine Fehlerbeurteilungseinheit (15), die konfiguriert ist, um zu bestimmen, dass kein Fehler in der Eingabedatenfolge vorliegt, wenn alle der Bits des Additionsergebnisses "0" sind, und anderenfalls zu bestimmen, dass ein Fehler vorliegt;
**dadurch gekennzeichnet, dass**:

der Restspeicher (11, 21) betriebsfähig ist, um Restwerte zu speichern, die Bitpositionen an jedem Intervall einer konstanten Anzahl von Bits entsprechen, und die Fehlererkennungsvorrichtung ferner eine Restinterpolationseinheit (22, 23, 24) umfasst, die konfiguriert ist, um Restwerte von Bitpositionen, die nicht gespeichert sind, unter Verwendung der gespeicherten Restwerte zu interpolieren; und
wenn das Intervall einer konstanten Anzahl von Bits als P genommen wird, die Restinterpolationseinheit betriebsfähig ist, um den Restwert für eine Bitposition $n \times P + k$ ($0 \leqq k < P$) durch Verschieben des Restwerts für die Bitposition $n \times P$ um k Bits nach links und Teilen dieses verschobenen Ergebnisses durch das Generatorpolynom zu berechnen.

## Revendications

1. Procédé de détection d'erreurs qui détecte si oui ou non une séquence de données d'entrée possède une erreur dans lequel la séquence de données d'entrée est créée dans un codeur en considérant une séquence de données possédant une longueur de bit spécifiée en tant que polynôme, en divisant ce polynôme par un polynôme pour générer un code de détection d'erreurs et en ajoutant le code de détection d'erreurs à la séquence de données de sorte que le reste est "0", comportant les étapes consistant à :

calculer les valeurs de reste en divisant les polynômes qui correspondent à une position de bit respective par ledit polynôme générateur et sauvegarder ces valeurs de reste préalablement dans une mémoire (11, 21) ;

entrer conjointement avec une séquence de données d'entrée, une information de position de bit qui indique la position de bit correcte de chaque donnée de la séquence de données d'entrée ;

trouver à partir de la mémoire des valeurs de reste qui correspondent aux positions de bit correctes des données de la séquence de données d'entrée qui ne sont pas "0" ;

effectuer une addition correspondant au bit de chacune des valeurs de reste trouvées ; et

déterminer qu'il n'existe pas d'erreur dans la séquence de données d'entrée lorsque tous les bits du résultat d'addition sont "0", et sinon déterminer qu'il existe une erreur ; **caractérisé par** :

dans lequel le calcul et la sauvegarde desdites valeurs de reste comprennent le calcul et la sauvegarde des valeurs de reste qui correspondent à chaque position de bit à chaque intervalle d'un nombre constant de bits, et

le fait de trouver des valeurs de reste comprend l'interpolation des valeurs de reste des positions de bit qui n'ont pas été sauvegardées en utilisant les valeurs de reste sauvegardées, et

dans lequel, lorsque ledit intervalle d'un nombre constant de bits est considéré comme étant P, la valeur de reste pour une position de bit n x P + k (0 ≤ k <P) est la valeur de reste obtenue en décalant la valeur de reste pour la position de bit n x P de k bits vers la gauche, et diviser ce résultat décalé par ledit polynôme générateur.

2. Dispositif de détection d'erreurs configuré pour détecter si oui ou non une séquence de données d'entrée présente une erreur, dans lequel les données d'entrée sont créées dans un codeur en considérant une séquence de données possédant une longueur de bit spécifiée en tant que polynôme, en divisant ce polynôme par un polynôme pour générer un code de détection d'erreurs et en ajoutant le code de détection d'erreurs à la séquence de données de sorte que le reste est "0", comportant :

une mémoire de reste (11, 21) configurée pour sauvegarder les valeurs de reste qui sont obtenues lorsque les polynômes correspondant à une position de bit respective sont divisés par ledit polynôme générateur ;

une unité d'addition (12, 13, 14) dans laquelle, conjointement avec une séquence de données d'entrée, une information de position de bit qui indique la position de bit correcte de chaque donnée de la séquence de données d'entrée est entrée, laquelle unité d'addition est configurée pour trouver des valeurs de reste à partir de ladite mémoire de reste qui correspondent aux positions de bit correctes des données de la séquence de données d'entrée qui ne sont pas "0", et effectuer une addition correspondant au bit de chacune des valeurs de reste trouvées ;

une unité d'estimation d'erreur (15) configurée pour déterminer qu'il n'y a pas d'erreur dans la séquence de données d'entrée lorsque tous les bits du résultat d'addition sont "0", et sinon déterminer qu'il existe une erreur ; **caractérisé par** :

dans lequel la mémoire de reste (11, 21) permet de sauvegarder des valeurs de reste qui correspondent aux positions de bit à chaque intervalle d'un nombre constant de bits, et le dispositif de détection d'erreur comporte en outre une unité d'interpolation de reste (22, 23, 24) configurée pour interpoler les valeurs de reste des positions de bit qui ne sont pas sauvegardées en utilisant les valeurs de reste sauvegardées ; et dans lequel, lorsque ledit intervalle d'un nombre constant de bits est considéré comme étant P, ladite unité d'interpolation de reste permet de calculer la valeur de reste pour une position de bit n x P + k (0 ≤ k < P) en décalant la valeur de reste de la position de bit n x P de k bits vers la gauche et diviser ce résultat décalé par ledit polynôme générateur.

## FIG. 1

DATA INPUT
$a_i$ ○

DATA NUMBER
i ○

REMAINDER
MEMORY

$R_i(x)$

⊗ 12

⊕ 13

▷ 14

R(x)

ERROR
DETECTION
UNIT

15

CHECK
RESULT
○

11

## FIG. 2

(a) PROCESSING TIME
OF THE PRIOR ART

DATA INPUT

CRC OPERATION

CHECK RESULT

≒2N

TIME

(b) PROCESSING TIME OF
THE PRESENT INVENTION

DATA INPUT

CRC OPERATION

CHECK RESULT

≒N

TIME

14

# FIG. 3

DATA INPUT $a_i$ — 1 — ⊗ (12) — 24 — ⊕ (13) — 24 — ▷ (14) — 24 — $R(x)$ → ERROR DETECTION UNIT (15) → CHECK RESULT

24 / $R_i(x)$

DATA NUMBER $i$ → REMAINDER MEMORY (11)

| $i$ | $R_i(x)$ |
|---|---|
| 0 | $R_0(x)$ |
| 1 | $R_1(x)$ |
| 2 | $R_2(x)$ |
| ... | ......... |
| N | $R_N(x)$ |

EP 2 187 525 B1

## FIG. 4

$$i: \quad \begin{array}{|c|c|} \hline & \\ n & k \\ & \\ \hline \end{array}$$

N       s   s$^{-1}$      0

$$P = 2^S$$

$$i = n \cdot P + k$$

$$k = 0 \sim 2^S - 1$$

$$n = 0 \sim 2^{(N-S+1)} - 1$$

## FIG. 5

| n | $R_{Pn}(x)$ |
|---|---|
| 0 | $R_{P0}(x)$ |
| 1 | $R_{P1}(x)$ |
| 2 | $R_{P2}(x)$ |
| ... | ......... |
| $n_{max}$ | $R_{Pnmax}(x)$ |

$$n_{max} = 2^{(N-S+1)} - 1$$

16

# FIG. 6

EP 2 187 525 B1

# FIG. 7

(A)

DATA NUMBER $i=32n+k$ → [12:0]

$n$ [12:5] → REMAINDER TABLE (21) → $R_{32n}(x)$ → SHIFT (22) → $I[54:0]$ → DIVISION (23) → $O[23:0]$ → REMAINDER VALUE $R_i(x)=R_{32n+k}$

$k$ [4:0] →

~20

(B)

DATA NUMBER $i=32n+k$

⇓ REMAINDER TABLE

| 23 | 0 |
|---|---|
| $R_{32n}(x)$ | |

$R_{32n}(x)$

⇓ SHIFT

| 54 | k+23 | k | 0 |
|---|---|---|---|
| 0..........0 | $R_{32n}(x)$ | 0.................0 | |

$I[54:0]=R_{32n}(x)X^k$

⇓ DIVISION

| 23 | 0 |
|---|---|
| $R_{32n+k}(x)$ | |

$O[23:0]=R_{32n+k}(x)$

EP 2 187 525 B1

# FIG. 8

| OUTPUT | OPERATION CONTENTS |
|---|---|
| O[23] | I[54]+I[53]+I[52]+I[51]+I[50]+I[49]+I[48]+I[47]+I[46]+I[40]+I[39]+I[38]+I[37]+I[36]+I[35]+I[34]+I[33]+I[32]+I[31]+I[30]+I[29]+I[28]+I[27]+I[26]+I[25]+I[24]+I[23] |
| O[22] | I[45]+I[40]+I[22] |
| O[21] | I[44]+I[39]+I[21] |
| O[20] | I[43]+I[38]+I[20] |
| O[19] | I[42]+I[37]+I[19] |
| O[18] | I[54]+I[41]+I[36]+I[18] |
| O[17] | I[53]+I[40]+I[35]+I[17] |
| O[16] | I[52]+I[39]+I[34]+I[16] |
| O[15] | I[51]+I[38]+I[33]+I[15] |
| O[14] | I[50]+I[37]+I[32]+I[14] |
| O[13] | I[49]+I[36]+I[31]+I[13] |
| O[12] | I[48]+I[35]+I[30]+I[12] |
| O[11] | I[47]+I[34]+I[29]+I[11] |
| O[10] | I[46]+I[33]+I[28]+I[10] |
| O[9] | I[45]+I[32]+I[27]+I[9] |
| O[8] | I[54]+I[44]+I[31]+I[26]+I[8] |
| O[7] | I[53]+I[43]+I[30]+I[25]+I[7] |
| O[6] | I[52]+I[42]+I[29]+I[24]+I[6] |
| O[5] | I[54]+I[53]+I[52]+I[50]+I[49]+I[48]+I[47]+I[46]+I[41]+I[40]+I[39]+I[38]+I[37]+I[36]+I[35]+I[34]+I[33]+I[32]+I[31]+I[30]+I[29]+I[27]+I[26]+I[25]+I[24]+I[5] |
| O[4] | I[50]+I[45]+I[27]+I[4] |
| O[3] | I[49]+I[44]+I[26]+I[3] |
| O[2] | I[48]+I[43]+I[25]+I[2] |
| O[1] | I[47]+I[42]+I[24]+I[1] |
| O[0] | I[54]+I[53]+I[52]+I[51]+I[50]+I[49]+I[48]+I[47]+I[41]+I[40]+I[39]+I[38]+I[37]+I[36]+I[35]+I[34]+I[33]+I[32]+I[31]+I[30]+I[29]+I[28]+I[27]+I[26]+I[25]+I[24]+I[0] |

# FIG. 9

# FIG. 10

FIG. 11

# FIG. 12

| (1) CRC ADDITION | CRC | INFORMATION |
| --- | --- | --- |

| | 0 | 1 | 2 | 3 | 5 |
| --- | --- | --- | --- | --- | --- |
| (2) SEPARATION | 0 1 2 ...... M−1 | M M+1 ...... 2M−1 | 2M 2M+1 ...... 3M−1 | 3M ...... 4M−1 | 4M ...... 5M−1 |

(3) PARALLEL ENCODING

| ENCODER /TCDR1 | ENCODER /TCDR2 | ENCODER /TCDR3 | ENCODER /TCDR4 | ENCODER /TCDR5 |
| --- | --- | --- | --- | --- |

(4) TRANSMISSION

(5) PARALLEL DECODING

| DECODER /TDEC1 | DECODER /TDEC2 | DECODER /TDEC3 | DECODER /TDEC4 | DECODER /TDEC5 |
| --- | --- | --- | --- | --- |

(6) PARALLEL CRC CHECK

PARALLEL TYPE CRC OPERATION DEVICE ~60

EP 2 187 525 B1

## FIG. 13

TRANSMISSION SIDE              1                                    3        RECEIVING SIDE

```
1a              1b              1c    (WRITE)  TRANS-   (READ)  3a              3b              3c
┌───────────┐  ┌───────────┐  ┌───────────┐         MISSION          ┌───────────┐  ┌───────────┐  ┌───────────┐
│INFORMATION│  │  ERROR    │  │  ERROR    │           PATH           │  ERROR    │  │  ERROR    │  │INFORMATION│
│GENERATION │→ │ DETECTION │→ │CORRECTION │──────────────────────────│CORRECTION │→ │ DETECTION │→ │EXTRACTION │
│           │  │ ENCODING  │  │ ENCODING  │            2             │ DECODING  │  │ DECODING  │  │           │
└───────────┘  └───────────┘  └───────────┘                          └───────────┘  └───────────┘  └───────────┘
```

RRQ
RETRANSMISSION (REREAD)
REQUEST SIGNAL

EP 2 187 525 B1

# FIG. 14

(A)

D | DELAY ELEMENT     ⊕ EXCLUSIVE OR

(B)

EP 2 187 525 B1

EP 2 187 525 B1

## FIG. 15

FIG. 16

# FIG. 17

# FIG. 18

## FIG. 19

## FIG. 20

# EP 2 187 525 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20030066011 A
- WO 0041312 A
- JP H5165660 A

**Non-patent literature cited in the description**

- Out of Order Incremental CRC Computation. *IEEE Transon Computers,* 2005, vol. 54 (9
- **J. SATRAN et al.** Out of Order Incremental CRC Computation. *IEEE Transactions on Computers,* September 2005, vol. 54 (9